# EUROPÄISCHE PATENTANMELDUNG

(11) **EP 1 006 762 A2**
(43) Veröffentlichungstag der Anmeldung: **07.06.2000**
(21) Anmeldenummer: 99120241.7
(22) Anmeldetag: 11.10.1999
(51) Int. Cl.: H05K 3/00, H05K 13/00

(54) **Anordnung zur Bearbeitung einer Leiterplatte**

(30) Priorität: 03.12.1998 DE 19855715
(71) Anmelder: Leuze electronic GmbH + Co., D-73277 Owen (DE)
(72) Erfinder: Seyfang, Werner, 73230 Kirchheim/Teck (DE)
(74) Vertreter: Ruckh, Rainer Gerhard, Dr.

(57) **Zusammenfassung**

Die Erfindung betrifft eine Anordnung zur Bearbeitung einer Leiterplatte (1). Die aus einem biegsamen, flexiblen Material bestehende Leiterplatte (1) weist in ihrem Randbereich Bohrungen (6) auf. Als Unterlage für die Leiterplatte (1) ist ein starrer Arbeitsnutzen (7) vorgesehen, wobei von einer Oberfläche des Arbeitsnutzens (7) Führungsstifte hervorstehen. Bei Aufbringen der Leiterplatte (1) auf den Arbeitsnutzen (7) durchsetzen die Führungsstifte die Bohrungen (6), so daß die Leiterplatte (1) auf der Oberfläche des Arbeitsnutzens (7) flach aufliegend an diesem fixiert ist.

## Beschreibung

Die Erfindung betrifft eine Anordnung zur Bearbeitung von Leiterplatten.

Die Bearbeitung derartiger Leiterplatten umfaßt insbesondere das Bedrucken mit Lot und das Aufbringen von elektronischen Bauelementen. Die auf diese Weise bearbeiteten Leiterplatten werden insbesondere bei Sensoren wie zum Beispiel Lichtschranken und Lichttastern eingesetzt. Auf der Leiterplatte ist dann typischerweise die Auswerteelektronik zur Auswertung der Sensorsignale integriert.

Die in Sensoren eingesetzten Leiterplatten bestehen üblicherweise aus einem starren Grundmaterial wie zum Beispiel FR4. Diese Leiterplatten können einzeln oder vorzugsweise in einer Mehrfachanordnung, einem sogenannten Mehrfachnutzen, Automaten zur Bedruckung und Bestückung zugeführt werden.

Da die Leiterplatten aus starrem Grundmaterial bestehen, können diese auf einfache Weise gehandhabt werden. Insbesondere können die Leiterplatten in genau definierten Positionen am Automaten angeordnet werden, so daß mittels automatischer Greifer oder dergleichen mit hoher Genauigkeit die Bearbeitung der Leiterplatten erfolgen kann.

Im Zuge der Miniaturisierung von Sensoren, insbesondere optischen Sensoren, werden zunehmend auch flexible Leiterplatten eingesetzt, welche platzsparend in den Gehäusen untergebracht werden können. Beispielsweise können derartige Leiterplatten mehrfach gefaltet im Inneren des Gehäuses eines Sensors angeordnet sein.

Nachteilig ist jedoch, daß derartige flexible Leiterplatten nur mit erhöhtem Aufwand bearbeitbar sind. Aufgrund ihrer mangelnden Formstabilität können derartige Leiterplatten nicht von Bestückungsautomaten mittels Greifern aufgegriffen werden. Da derartige Leiterplatten nicht in einer vorgegebenen Position verbleiben, können diese auch nicht von Automaten positionsgenau bedruckt und bestückt werden.

Der Erfindung liegt die Aufgabe zugrunde eine Anordnung für flexible Leiterplatten zu schaffen, daß diese möglichst rationell bearbeitbar sind.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Der Grundgedanke der Erfindung besteht darin, daß eine oder mehrere flexible Leiterplatten auf eine starre Unterlage, welche einen Arbeitsnutzen bildet, aufbringbar sind, so daß die so gebildete Anordnung positionsgenau Automaten zur Bedruckung und Bestückung der Leiterplatten zuführbar ist.

Erfindungsgemäß weist dabei die flexible Leiterplatte in ihrem Randbereich eine vorgegebene Anzahl von Bohrungen auf. Der Arbeitsnutzen, der zweckmäßigerweise aus einer aus FR4-Material bestehenden Platte gebildet ist, weist an einer seiner Oberflächen zu den Bohrungen der Leiterplatte korrespondierende Führungsstifte auf, welche von der Oberfläche hervorstehen.

Bei Aufbringen der Leiterplatte auf den Arbeitsnutzen werden zunächst die Führungsstifte des Arbeitsnutzens in die entsprechenden Bohrungen in der Leiterplatte eingeführt. Dann wird der Arbeitsnutzen gegen die Leiterplatte gedrückt, so daß die Leiterplatte auf dem Arbeitsnutzen flach aufliegt. Beim Aufpressen wird zugleich die Leiterplatte am Arbeitsnutzen fixiert. Die Fixierung erfolgt zweckmäßigerweise dadurch, daß die Leiterplatte am Arbeitsnutzen festgeklebt wird. Hierzu ist vorzugsweise auf der Oberfläche des Arbeitsnutzens ein doppelseitiges Klebeband aufgebracht, mit welchem die Leiterplatte in ihrem Randbereich, welcher für die spätere Bearbeitung nicht genutzt wird, festgeklebt ist.

Wesentlich bei dieser Anordnung ist, daß die Führungsstifte auf dem Arbeitsnutzen so angeordnet sind, daß die Leiterplatte in den Bohrungen mit einer geringen Spannung gehalten ist, so daß bei Aufpressen des Arbeitsnutzen und bei dem dabei erfolgten Fixiervorgang die Leiterplatte flach und ohne Falten auf dem Arbeitsnutzen aufliegt.

Die Leiterplatte oder die Leiterplatten auf einem Arbeitsnutzen können anschließend wie starre Leiterplatten rationell mittels eines Automaten mit Lot bedruckt und mit elektronischen Bauteilen bestückt werden.

Nach diesen Bearbeitungsvorgängen können vorteilhafterweise die Leiterplatten am Arbeitsnutzen ausgestanzt werden, wobei die am Arbeitsnutzen fixierten Randbereiche der Leiterplatten als Ausschuß am Arbeitsnutzen verbleiben.

Die Erfindung wird im nachstehenden anhand der Zeichnungen erläutert. Es zeigen:
- Figur 1:: Draufsicht auf eine flexible Leiterplatte für einen Sensor vor dem Bedruckungs- und Bestückungsprozeß.
- Figur 2:: Draufsicht auf einen Arbeitsnutzen zur Aufnahme von sechs Leiterplatten gemäß Figur 1.
- Figur 3:: Konturverlauf eines Klebebands zur Fixierung einer Leiterplatte auf dem Arbeitsnutzen gemäß Figur 2.
- Figur 4:: Arbeitsnutzen gemäß Figur 2 mit sechs darauf fixierten Leiterplatten gemäß Figur 1.

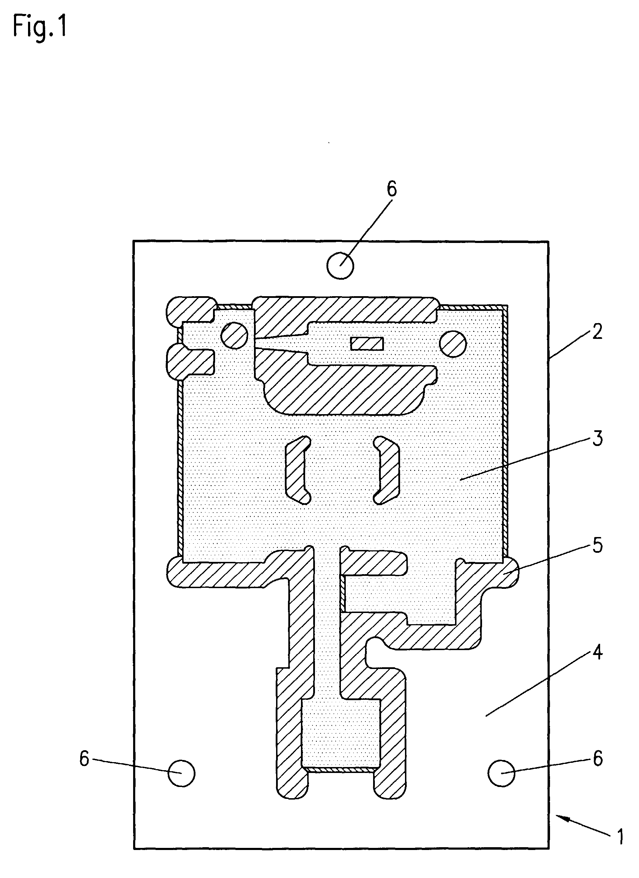

Figur 1 zeigt ein Ausführungsbeispiel einer flexiblen Leiterplatte 1. Die dargestellte Leiterplatte 1 kann insbesondere in Sensoren wie zum Beispiel Lichtschranken, Lichttastern oder dergleichen eingesetzt werden. Typischerweise wird auf derartigen Leiterplatten 1 die Auswerteelektronik zur Auswertung der Sensorsignale angeordnet. Zudem oder alternativ können auf der Leiterplatte 1 optische aktive Bauelemente angeordnet sein. Diese Bauelemente können von Leuchtdioden, Photodioden oder dergleichen gebildet sein.

Die in Figur 1 dargestellte flexible Leiterplatte 1 befindet sich im Rohzustand, so daß sich noch keine Bauelemente auf der Leiterplatte 1 befinden. Die flexible Leiterplatte 1 weist eine rechteckige Außenkontur 2 auf. Dabei stellt lediglich der gepunktet hervorgehobene innere Bereich der Leiterplattenoberfläche die Nutzfläche 3 dar, auf welche in späteren Bearbeitungsschritten die elektronischen Bauelemente der Auswerteelektronik aufgebracht werden. Demgegenüber bildet der äußere Randbereich der Leiterplatte 1 einen Hilfsrahmen 4, welcher für den Bestückungsvorgang mit elektronischen Bauelementen nicht benötigt wird. Die schraffiert dargestellten Flächen stellen Aussparungen 5 in der flexiblen Leiterplatte 1 dar.

In dem Randbereich der Leiterplatte 1 sind drei kreisförmige Bohrungen 6 vorgesehen, welche die Leiterplatte 1 durchsetzen. Die Bohrungen 6 weisen jeweils denselben Durchmesser auf.

Dabei ist jeweils eine Bohrung 6 im Bereich einer Ecke des unteren Randes der Leiterplatte 1 angeordnet. Die dritte Bohrung 6 befindet sich in der Mitte des oberen Randes der Leiterplatte 1. Dabei sind sämtliche Bohrungen 6 im Bereich des Hilfsrahmens 4 der Leiterplatte 1 außerhalb der Nutzfläche 3 angeordnet.

Zum Aufbringen von elektronischen Bauelementen auf die flexible Leiterplatte 1 werden diese üblicherweise zunächst mit Lot bedruckt und dann mit den elektronischen Bauelementen bestückt.

Damit diese Bearbeitungsschritte rationell mittels Automaten durchgeführt werden können, werden die Leiterplatten 1 auf starren Arbeitsnutzens 7 fixiert. Diese Arbeitsnutzen 7 bilden formstabile Unterlagen, die mittels der Automaten auf einfache Weise und mit reproduzierbaren Ergebnissen bearbeitbar sind.

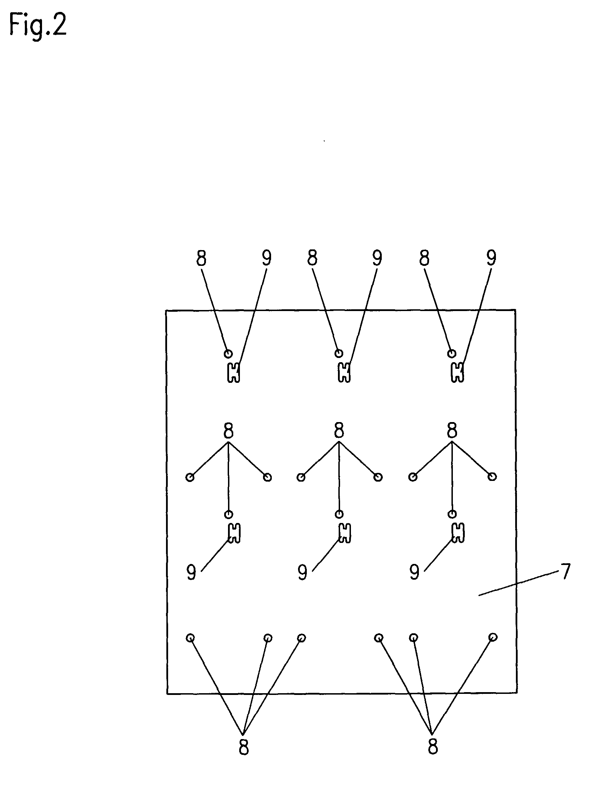

Ein Ausführungsbeispiel eines derartigen Arbeitsnutzens 7 ist in Figur 2 dargestellt. Der Arbeitsnutzen 7 besteht aus einer rechteckigen Platte, welche vorzugsweise aus FR4-Material besteht. Im vorliegenden Ausführungsbeispiel können auf dem Arbeitsnutzen 7 insgesamt sechs Leiterplatten 1 gemäß Figur 1 angeordnet werden. Zur Anbringung der Leiterplatten 1 auf dem Arbeitsnutzen 7 weist dieser insgesamt achtzehn kreisförmige Aufnahmebohrungen 8 auf. Jeweils drei dieser Aufnahmebohrungen 8 entsprechen in ihrer Anordnung der Anordnung der drei Bohrungen 6 auf einer Leiterplatte 1. Die Durchmesser der Aufnahmebohrungen 8 entsprechen dabei im wesentlichen den Durchmessern der Bohrungen 6 in den Leiterplatten 1. Zudem sind im Arbeitsnutzen 7 sechs weitere großflächigere Aussparungen 9 vorgesehen. Diese Aussparungen 9 sind jeweils der Nutzfläche 3 einer Leiterplatte 1 zugeordnet. Der Zweck dieser Aussparungen 9 besteht darin, daß während des Bedruckungsvorgangs und / oder Bestückungsvorgangs die auf den Arbeitsnutzen 7 angeordnete Leiterplatte 1 an dieser Stelle sowohl von der Unter- als auch von der Oberseite zugänglich ist und so von beiden Seiten bearbeitet werden kann.

Die Fixierung der Leiterplatten 1 am Arbeitsnutzen 7 erfolgt in folgenden Arbeitsschritten. Zunächst werden von der Oberseite des Arbeitsnutzens 7 in die achtzehn Aufnahmebohrungen 8 nicht dargestellte, identische Führungsstifte eingesteckt. Diese Führungsstifte sitzen formschlüssig in den Aufnahmebohrungen 8 und stehen jeweils mit ihrem oberen freien Ende senkrecht von der Oberfläche des Arbeitsnutzens 7 hervor. Dabei entspricht der Außendurchmesser des über den Arbeitsnutzen 7 hervorstehenden Teils eines des Führungsstifts im unteren Bereich im wesentlichen dem Durchmesser der Bohrung 6 einer Leiterplatte 1. Zur Spitze des Führungsstiftes hin verjüngt sich sein Durchmesser kontinuierlich.

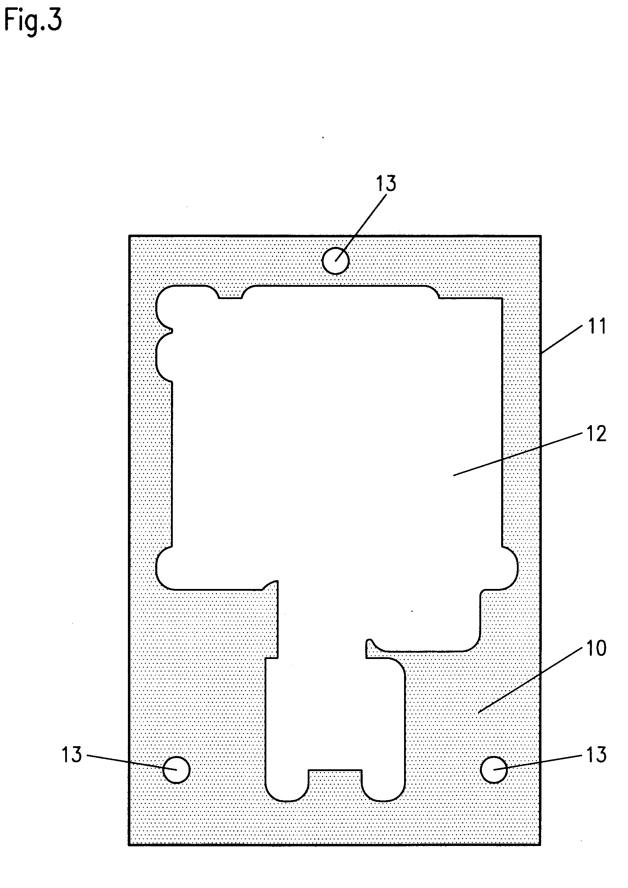

Die Leiterplatten 1 werden mittels Streifen von doppelseitigem Klebeband 10 am Arbeitsnutzen 7 fixiert. Ein derartiges Klebeband 10 zur Fixierung einer Leiterplatte 1 ist in Figur 3 dargestellt. Die Außenkontur 11 des Klebebands 10 entspricht der Außenkontur 2 der flexiblen Leiterplatte 1 gemäß Figur 1. Dieses Klebeband 10 weist im Innern eine Aussparung 12 auf, deren Fläche der Summe der Nutzfläche 3 und der Aussparungen 5 der Leiterplatte 1 gemäß Figur 1 entspricht. Demzufolge ist die Fläche des Klebebands 10 im wesentlichen deckungsgleich mit der Fläche des Hilfsrahmens 4 der Leiterplatte 1 gemäß Figur 1. Im Klebeband 10 sind drei kreisförmige Bohrungen 13 vorgesehen, welche hinsichtlich Form, Größe und Anordnung den Bohrungen 6 in der Leiterplatte 1 gemäß Figur 1 entsprechen. Daher korrespondieren diese Bohrungen 13 auch mit der Anordnung von jeweils drei Aufnahmebohrungen 8 im Arbeitsnutzen 7.

Das Klebeband 10 gemäß Figur 3 wird auf der Oberfläche des Arbeitsnutzens 7 aufgeklebt. Hierzu werden die Bohrungen 13 des Klebebands 10 auf die entsprechenden Führungsstifte am Arbeitsnutzen 7 gesteckt. Da die Lagen der Führungsstifte mit den Lagen der Bohrungen 13 im Klebeband 10 korrespondieren, wird durch die Führung der Bohrungen 13 an den Führungsstiften 10 das Klebeband 10 ohne Falten zu werfen auf die Oberfläche des Arbeitsnutzens 7 aufgesetzt.

Auf diese Weise werden insgesamt sechs streifenförmige Klebebänder 10 auf den Arbeitsnutzen 7 aufgeklebt, so daß diese schließlich zwei untereinanderliegende Reihen von jeweils drei nebeneinanderliegend angeordneten Klebebändern 10 bilden.

Die auf den Arbeitsnutzen 7 aufzubringenden sechs Leiterplatten 1 werden vorzugsweise in eine nicht dargestellte Vorrichtung eingelegt. Dort sind die Leiterplatten 1 entsprechend der Anordnung der Klebebänder 10 auf dem Arbeitsnutzen 7 angeordnet und in dieser Position gehalten. Zweckmäßigerweise kann die Vorrichtung aus einem Rahmen mit einem Einsatz bestehen. Die Leiterplatten 1 liegen dann in zwei untereinanderliegenden Dreier-Reihen jeweils in einer flächigen Ausnehmung des Einsatzes und werden dort so gehalten, daß die Oberseiten der Leiterplatten 1 flach auf der Oberfläche der jeweiligen Ausnehmung aufliegen.

Anschließend werden die Schutzfolien der doppelseitigen Klebebänder 10 auf dem Arbeitsnutzen 7 entfernt, so daß die Klebeflächen der Klebebänder 10 freiliegen. Dann wird der Arbeitsnutzen 7 von oben auf die Vorrichtung geführt, so daß die Spitzen der Führungsstifte in die korrespondierenden Bohrungen 6 der entsprechenden Leiterplatten 1 ragen. Dabei sind zunächst noch die Oberflächen der Klebebänder 10 in geringem Abstand zu den Leiterplatten 1 angeordnet.

Das Einführen der Spitzen der Führungsstifte in die Bohrungen 6 der Leiterplatten 1 wird dadurch erleichtert, daß sich die Führungsstifte zu ihrem oberen Rand hin verjüngen. Demzufolge brauchen die Bohrungen 6 der Leiterplatten 1 in der Vorrichtung nicht exakt ausgerichtet sein, damit diese von den Spitzen der Führungsstifte durchsetzt werden.

Daraufhin wird der Arbeitsnutzen 7 stoßartig mit vorgegebenem Anpreßdruck gegen die Vorrichtung gepreßt. Dabei gleiten die Innenwände der Bohrungen 6 der Leiterplatten 1 an den jeweiligen Führungsstiften abwärts bis die Leiterplatte 1 mit ihrer Unterseite auf dem jeweiligen Klebeband 10 flach aufliegt. In dieser Position liegen die Innenwände der Bohrungen 6 der Leiterplatte 1 am unteren Rand der Führungsstifte formschlüssig an, so daß die Leiterplatten 1 an den Führungsstiften ohne Spiel gehalten sind. Da zudem die Lagen der Bohrungen 6 in der Leiterplatte 1 mit den Lagen der Führungsstifte am Arbeitsnutzen 7 korrespondieren, ist gewährleistet, daß durch das Andrücken des Arbeitsnutzens 7 an die Leiterplatten 1 diese flach aufliegend auf dem Klebeband 10 fixiert werden. Somit wird erreicht, daß bei Aufbringen der flexiblen Leiterplatten 1 auf die Klebebänder 10 keinerlei Falten oder Aufwerfungen bei den Leiterplatten 1 erzeugt werden. Insbesondere wird durch diese Fixierung der Leiterplatten 1 am Arbeitsnutzen 7 erreicht, daß ein Aufbäumen der Leiterplatte 1 am Arbeitsnutzen 7 verhindert wird. Dies ist eine wesentliche Voraussetzung dafür, daß in den nachfolgenden Bearbeitungsschritten die Bauelemente positionsgenau auf den Leiterplatten 1 aufgebracht werden können.

Nach diesem Fixiervorgang werden die Führungsstifte wieder aus den Aufnahmebohrungen 8 im Arbeitsnutzen 7 entfernt.

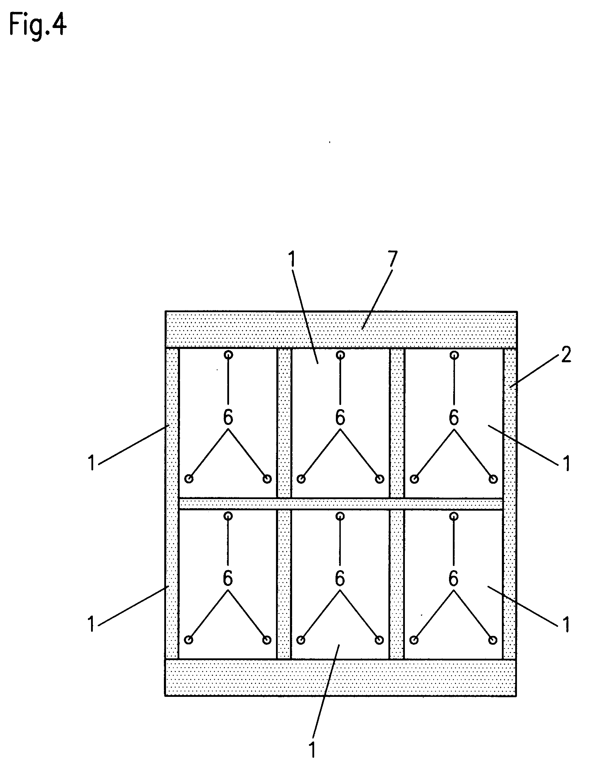

Den auf diese Weise bearbeiteten Arbeitsnutzen 7 zeigt Figur 4. Die auf dem Arbeitsnutzen 7 mittels der Klebebänder 10 fixierten Leiterplatten 1 sind in zwei Dreier-Reihen auf der Oberfläche des Arbeitsnutzens 7 fixiert. Die Bohrungen 6 in jeder Leiterplatte 1 korrespondieren mit den entsprechenden Aufnahmebohrungen 8 im Arbeitsnutzen 7. Da die Außenkontur 11 des Klebebands 10 mit der Außenkontur 2 einer Leiterplatte 1 übereinstimmt, schließen der Außenrand der Leiterplatte 1 und der Außenrand des Klebebandes 10 bündig ab. Dies hat den Vorteil, daß einerseits das Klebeband 10 nicht über die Leiterplatte 1 hervorsteht, so daß keine freie klebende Fläche auf dem Arbeitsnutzen 7 verbleibt, was die nachfolgenden Bearbeitungsschritte erschweren würde. Andererseits ist vorteilhaft, daß auch der äußerste Rand der Leiterplatte 1 mit dein Klebeband 10 fixiert ist, wodurch verhindert wird, daß einzelne Ecken der Leiterplatte 1 vom Arbeitsnutzen 7 abstehen.

Die auf dem Arbeitsnutzen 7 fixierten Leiterplatten 1 werden anschließend mit Lot bedruckt und mit elektronischen Bauelementen bestückt. Da der Arbeitsnutzen 7 eine starre Unterlage für die Leiterplatten 1 bildet, kann die Bedruckung und die Bestückung der Leiterplatten 1 mittels Automaten erfolgen. Dabei können die Arbeitsnutzen 7 insbesondere mit Greifern auf einfache Weise aufgegriffen werden und am gewünschten Bearbeitungsort positioniert werden.

Die Bedruckung mit Lot und die Bestückung mit Bauelementen erfolgt über rechnergesteuerte Einrichtungen an den jeweiligen Automaten. Hierzu müssen die jeweiligen Einrichtungen an den hierfür vorgesehenen Abschnitten der Leiterplatten 1 positioniert werden. Besonders vorteilhaft können die Bohrungen 6 in den Leiterplatten 1 als Fixpunkte dienen, anhand derer dann die Positionierung der Einrichtungen erfolgen kann.

Nach diesen Bearbeitungsvorgängen werden die Leiterplatten 1 durch Ausstanzen wieder vom jeweiligen Arbeitsnutzen 7 entfernt. Besonders vorteilhaft wird dabei nur die Nutzfläche 3 mit den Aussparungen 5 der Leiterplatte 1 ausgestanzt, während der festgeklebte Hilfsrahmen 4 am Arbeitsnutzen 7 verbleibt. Zweckmäßigerweise wird der Arbeitsnutzen 7 mit dem daran verbleibenden Hilfsrahmen 4 einem Recyclingprozeß zugeführt, wobei aus dem so wiedergewonnenen FR4 Rohmaterial neue Arbeitsnutzen 7 herstellbar sind.

## Patentansprüche

1. Anordnung zur Bearbeitung einer Leiterplatte, dadurch gekennzeichnet, daß die aus einem biegsamen, flexiblen Material bestehende Leiterplatte (1) in ihrem Randbereich Bohrungen (6) aufweist, daß als Unterlage für die Leiterplatte (1) ein starrer Arbeitsnutzen (7) vorgesehen ist, wobei von einer Oberfläche des Arbeitsnutzens (7) Führungsstifte hervorstehen, daß bei Aufbringen der Leiterplatte (1) auf den Arbeitsnutzen (7) die Führungsstifte die Bohrungen (6) durchsetzen, und daß die Leiterplatte (1) auf der Oberfläche des Arbeitsnutzens (7) flach aufliegend an diesem fixiert ist.

2. Anordnung nach Anspruch 1, dadurch gekennzeichnet, daß der Arbeitsnutzen (7) zu den Bohrungen (6) der Leiterplatte (1) korrespondierende Aufnahmebohrungen (8) aufweist, in welche die Führungsstifte einsetzbar sind.

3. Anordnung nach einem der Ansprüche 1 oder 2, dadurch gekennzeichnet, daß die Leiterplatte (1) auf dem Arbeitsnutzen (7) aufgeklebt ist.

4. Anordnung nach Anspruch 3, dadurch gekennzeichnet, daß auf dem Arbeitsnutzen (7) ein streifenförmiges doppelseitiges Klebeband (10) aufgeklebt ist, mit welchem der Randbereich der Leiterplatte (1) fixiert ist.

5. Anordnung nach Anspruch 4, dadurch gekennzeichnet, daß das Klebeband (10) bündig mit dem Außenrand der Leiterplatte (1) abschließt.

6. Anordnung nach einem der Ansprüche 1 - 5, dadurch gekennzeichnet, daß der Arbeitsnutzen (7) aus einer Platte aus FR4-Material besteht.

7. Anordnung nach einem der Ansprüche 1 - 6, dadurch gekennzeichnet, daß sich die Durchmesser der Führungsstifte zu ihrem oberen Ende hin verjüngen, wobei die Ränder der Bohrungen (6) bei auf dem Arbeitsnutzen (7) aufliegender Leiterplatte (1) formschlüssig an den Führungsstiften anliegen.

8. Anordnung nach einem der Ansprüche 1 - 7, dadurch gekennzeichnet, daß die Leiterplatte (1) drei kreisförmige Bohrungen (6) aufweist.

9. Anordnung nach Anspruch 8, dadurch gekennzeichnet, daß die Leiterplatte (1) eine im wesentlichen rechteckige Außenkontur (2) aufweist, und daß jeweils eine Bohrung (6) an einer Ecke des unteren Randes der Leiterplatte (1) angeordnet ist, und die dritte Bohrung (6) am oberen Rand der Leiterplatte (1) angeordnet ist.

10. Anordnung nach einem der Ansprüche 1 - 9, dadurch gekennzeichnet, daß auf dem Arbeitsnutzen (7) mehrere Leiterplatten (1) fixiert sind.

11. Anordnung nach Anspruch 10, dadurch gekennzeichnet, daß die Leiterplatten (1) in mehreren Reihen auf dem Arbeitsnutzen (7) angeordnet sind, wobei in jeder Reihe mehrere Leiterplatten (1) mit jeweils identischen Anordnungen von Bohrungen (6) in Abstand nebeneinanderliegend angeordnet sind.

12. Anordnung nach Anspruch 10 oder 11, dadurch gekennzeichnet, daß die Leiterplatten (1) für einen Arbeitsnutzen (7) in eine Vorrichtung einführbar sind und dort in den Außenkonturen (2) der Leiterplatten (1) angepaßten Ausnehmungen liegen, und daß der Arbeitsnutzen (7) mit vorgegebenem Anpreßdruck zur Fixierung der Leiterplatten (1) auf dessen Oberfläche gegen die Vorrichtung anpreßbar ist.

13. Anordnung nach einem der Ansprüche 1 - 12, dadurch gekennzeichnet, daß die auf dem Arbeitsnutzen (7) fixierten Leiterplatten (1) mit Lot bedruckt und mit elektronischen Bauelementen bestückt werden.

14. Anordnung nach Anspruch 13, dadurch gekennzeichnet, daß die Bedruckung und / oder die Bestückung der Leiterplatten (1) mittels Automaten erfolgt, wobei die Bohrungen (6) in den Leiterplatten (1) sowie die korrespondierenden Aufnahmebohrungen (8) in dem Arbeitsnutzen (7) als Fixpunkte für die Positionierung der Automaten dienen.

15. Anordnungen nach einem der Ansprüche 13 oder 14, dadurch gekennzeichnet, daß die bearbeiteten Leiterplatten (1) durch Ausstanzen von dem Arbeitsnutzen (7) entfernbar sind.

16. Anordnung nach Anspruch 15, dadurch gekennzeichnet, daß nur die inneren, nicht am Arbeitsnutzen (7) fixierten Bereiche der Leiterplatten (1) ausgestanzt werden.

17. Anordnung nach einem der Ansprüche 1 - 16, dadurch gekennzeichnet, daß auf der Leiterplatte (1) die Auswerteelektronik für einen Sensor, insbesondere einen optischen Sensor, integriert ist.
